# EUROPÄISCHE PATENTSCHRIFT

(11) **EP 3 901 872 B1**
(45) Veröffentlichungstag und Bekanntmachung des Hinweises auf die Patenterteilung: **07.08.2024**
(21) Anmeldenummer: 21180144.4
(22) Anmeldetag: 06.04.2017
(51) Int. Cl.: G06Q 10/0631, G06Q 50/08, G09B 9/04, G09B 19/16, G06Q 10/067

(54) **VERFAHREN UND VORRICHTUNG ZUM STEUERN DES BETRIEBS EINER BAUMASCHINE**
METHOD AND DEVICE FOR CONTROLLING OPERATION OF CONSTRUCTION MACHINE
PROCÉDÉ ET DISPOSITIF DE COMMANDE DU FONCTIONNEMENT D'UNE MACHINE DE CONSTRUCTION

(30) Priorität: 08.04.2016 DE 102016004382
(43) Veröffentlichungstag der Anmeldung: 27.10.2021
(62) Teilanmeldung aus: 17717322.6
(73) Patentinhaber: Liebherr-Werk Biberach GmbH, 88400 Biberach an der Riss (DE)
(72) Erfinder: BRAMBERGER, Robert, 82293 Mittelstetten/Vogach (DE)
(74) Vertreter: Thoma, Michael

(56) Entgegenhaltungen:
- WO-A1-2016/019158
- WO-A2-2013/006625
- DE-A1- 102013 212 686

## Beschreibung

Die vorliegende Erfindung betrifft ein Verfahren zum Steuern des Betriebs einer Baumaschine, insbesondere in Form eines Krans wie Turmdrehkran, unter Verwendung eines Bauwerkdatenmodells, das digitale Informationen über ein zu errichtendes und/oder zu bearbeitendes Bauwerk enthält. Die Erfindung betrifft dabei auch die Baumaschine selbst, die an ein solches Bauwerkdatenmodell anbindbar ist und/oder unter Verwendung eines solchen Bauwerkdatenmodells steuerbar ist.

Für das Planen, Errichten, Bearbeiten und Überprüfen von Bauwerken werden in jüngerer Zeit digitale Bauwerkdatenmodelle für alle am Bauwerk beteiligten Gewerke verwendet. Die dazu entwickelte Methode ist unter dem Begriff Building Information Modelling bekannt. In dieser als BIM-Modell bezeichneten Datenbasis sind digitale Informationen über das zu errichtende bzw. zu bearbeitende Bauwerk enthalten. Solche Bauwerkdatenmodelle oder BIM-Modelle sind in der Regel computerlesbare Dateien oder Dateikonglomerate und ggfs. verarbeitende Computerprogramm-Bausteine zum Verarbeiten solcher Dateien, in denen Informationen und Charakteristika, die das zu errichtende bzw. zu bearbeitende Bauwerk und dessen relevante Eigenschaften in Form digitaler Daten beschreiben. Insbesondere können solche Bauwerkdatenmodelle zwei-, drei- oder mehrdimensionale CAD-Daten zur Visualisierung des Bauwerks und/oder dessen Bauwerksteile enthalten, aber auch andere relevante Informationen über das Bauwerk, beispielsweise dessen Zeitplan zu seiner Errichtung, Informationen über die umgebende Infrastruktur wie Zufahrtsstraßen, Energie- und Wasserversorgung, oder logistische Informationen über benötigte Hilfsmittel für die Errichtung bzw. Bearbeitung des Bauwerks, umfassen. Als charakteristische Bauwerksdaten sind oft Bauwerksgrößen wie Bauvolumen, Bauwerkshöhe, Erstreckungsmaße im Aufriss, Materialvolumina wie benötigtes Betonvolumen, Ziegelsteinvolumen etcetera, oder Bauteilgewichte von einzelnen Bauwerkskomponenten wie Stahlträgern, Fertigbauteilen oder ähnliches enthalten. Das Bauwerkdatenmodell und seine Dateien bzw. das Dateienkonglomerat ist dabei häufig verschickbar und/oder netzwerkfähig, um verschiedenen Baubeteiligten zur Verfügung zu stehen.

Mit Hilfe solcher Bauwerkdatenmodelle werden viele Prozesse bei der Errichtung eines Bauwerks computergestützt bearbeitet, wobei beispielsweise in der klassischen Bauplanung ein Architekt einen Entwurf erstellt und diesen mit Hilfe von CAD-Systemen zeichnet, woraufhin dann zur Kostenkalkulation auf Basis der CAD-Zeichnungen eine Mengenermittlung erstellt werden kann oder die Pläne anderen Fachingenieuren, Brandschutzgutachtern oder Behörden vorgelegt werden können. Treten Planungsänderungen auf, werden die Zeichnungen geändert und mit den Beteiligten abgeglichen, wird die Mengenermittlung angepasst und die Kostenkalkulation überarbeitet, was sich alles unter Zuhilfenahme des integrierten BIM-Modell deutlich vereinfacht und von Softwarebausteinen, die auf die Daten des Bauwerkdatenmodells zugreifen können, teilweise automatisch erledigt wird.

In diesem Kontext wurde bereits vorgeschlagen, Daten betreffend den Betrieb eines Krans an ein BIM- bzw. Bauwerkdatenmodell anzubinden. Die Schrift WO 2016/019158 A1 beschreibt beispielsweise ein Verfahren, mittels dessen ein BIM-Modell durch Kranbetriebsdaten aktualisiert wird, wobei anhand der durch den Kran zu versetzenden Bauteile eine Zeitschiene bzw. ein Zeitplan generiert wird, die die benötigten Kraneinsätze beinhaltet und in das Datenmodell der BIM-Umgebung integriert wird. Das Datenmodell kann dann anhand der generierten Zeitschiene weitere BIM-Funktionen aktualisieren.

Ferner beschreibt die Schrift WO 2013/006625 A2 ein Verfahren zum Manövrieren eines Krans innerhalb einer Baustelle unter Zuhilfenahme von Daten aus einem BIM-Modell, wobei einerseits globale 3D-Koordinaten des Kranhakens, die mit Hilfe von absoluten Positionssensoren bestimmt werden, und andererseits globale 3D-Koordinaten, die das zu errichtende Bauwerk und die Position der Bauwerksteile charakterisieren und im BIM-Modell abgelegt sind, miteinander abgeglichen werden.

Die Offenlegungsschrift DE 10 2013 212686 A1 offenbart ein Verfahren zum Darstellen einer mobilen Arbeitsmaschine, insbesondere einer Baumaschine, in einer virtuellen Realität unter Verwendung eines Bauwerkdatenmodells, wobei insbesondere eine Arbeitsbereichbegrenzungsfunktion zur Unterstützung der Steuerung des Betriebs einer mobilen Arbeitsmaschine vorgesehen ist.

Im Ergebnis ist der funktionale Zugewinn der bislang vorgesehenen Anbindung eines Krans an das BIM-Modell jedoch begrenzt. Insbesondere konnten bislang keine durchschlagenden Vorteile bei der Steuerung von Baumaschinen wie Kranen oder Baggern und deren Handhabung durch BIM-Modelle erzielt werden.

Der vorliegenden Erfindung liegt daher die Aufgabe zugrunde, eine verbesserte Integration von Baumaschinen und deren Betrieb in Bauwerkdatenmodelle und/oder eine verbesserte Anbindung von Baumaschinen an solche Bauwerkdatenmodelle zu schaffen, die Nachteile des Standes der Technik vermeiden und letzteren in vorteilhafter Weise weiterbilden. Insbesondere soll eine effizientere und sicherere Steuerung von Baumaschinen durch eine verbesserte Anbindung an BIM-Modelle erzielt werden.

Erfindungsgemäß wird die genannte Aufgabe durch ein Verfahren gemäß Anspruch 1 und eine Baumaschine gemäß Anspruch 7 gelöst. Bevorzugte Ausgestaltungen der Erfindung sind Gegenstand der abhängigen Ansprüche.

Es wird also nach einem Aspekt der Erfindung vorgeschlagen, die Steuerung einer auf der Baustelle tatsächlich verwendeten Baumaschine an das Bauwerkdatenmodell bzw. das BIM-Modell anzubinden. Insbesondere wird anhand digitaler Informationen aus dem Bauwerkdatenmodell in die Steuerung der Baumaschine eingegriffen und die Steuerung der Baumaschine parametrisiert und modifiziert.

Ein solcher Eingriff in die Baumaschinensteuerung kann beispielsweise die Anpassung einer dort implementierten Arbeitsbereichsbegrenzung an Bauwerksdaten aus dem Bauwerkdatenmodell umfassen, wobei vorteilhafterweise eine zeitlich dynamische Anpassung dergestalt erfolgen kann, dass die Arbeitsbereichsbegrenzung an sich ergebende Baufortschritte angepasst werden kann bzw. nach und nach verändert werden kann.

Ein Maschinendatenmodell, in dem digitale Informationen über verschiedene Baumaschinenmodelle enthalten sind, kann an das Bauwerkdatenmodell bzw. das BIM-Modell angebunden werden und Charakteristika der zur Verfügung stehenden Baumaschinen bereits bei der Planung berücksichtigen. Das genannte Maschinendatenmodell kann dabei in Form eines Software-Bausteins oder einer App bereitgestellt werden, der/die eine Schnittstelle zur Kommunikation mit dem Bauwerkdatenmodell besitzt und beispielsweise von einem Server oder einem Software-Store heruntergeladen oder auch auf einem Datenträger gespeichert sein kann.

Mittels des Maschinendatenmodells kann ein automatisches Auswählen einer für die Errichtung und/oder Bearbeitung des jeweiligen Bauwerks geeigneten Baumaschine anhand digitaler Informationen aus dem Bauwerkdatenmodell und aus dem Maschinendatenmodells erfolgen, wobei hierfür ein automatisches Identifizieren und Auslesen von relevanten Informationen aus dem Bauwerkdatenmodell anhand von Kriterien erfolgen kann, die von dem Maschinendatenmodell vorgegeben werden und Maschinendaten betreffen, in denen sich die verschiedenen Baumaschinenmodelle voneinander unterscheiden. Anhand eines automatischen Vergleichens der ausgelesenen Informationen aus dem Bauwerkdatenmodell mit den Maschinendaten verschiedener Baumaschinen aus dem Maschinendatenmodell kann sodann das automatische Auswählen der geeigneten Baumaschine erfolgen.

Die die genannten Funktionen realisierenden Bausteine können insbesondere in Form von Software-Tools in das Maschinendatenmodell integriert sein, ggfs. aber auch in dem Bauwerkdatenmodell realisiert sein. Bei Integration in das anbindbare Maschinendatenmodell kann die gesamte Funktionalität für das automatische Auswählen der passenden Baumaschine von dem herunterladbaren und/oder einspielbaren Software-Tool, welches das Maschinendatenmodell realisiert, bereitgestellt werden und insofern mit einem BIM- bzw. Bauwerkdatenmodell gearbeitet werden, das hierfür lediglich eine entsprechende Schnittstelle benötigt, über die das ergänzende Software-Tool angebunden werden kann.

Die relevanten Informationen aus dem Bauwerkdatenmodell, die für die Auswahl der Baumaschine benötigt werden und von einem Identifikations- und/oder Auslesemodul identifiziert und ausgelesen werden, können verschiedene Bauwerkscharakteristika wie beispielsweise die Bauwerkshöhe, das Gewicht des schwersten zu versetzenden Bauteils, die Fläche und/oder die Querschnittserstreckung des Bauwerks im Aufriss und/oder die maximale Entfernung zwischen einer im BIM abgelegten Bauteilanlieferungsstation und einem Bauteilbestimmungsort, an dem das jeweilige Bauteil verbaut werden soll, umfassen. Diese identifizierten und ausgelesenen Bauwerkscharakteristika können von einem Vergleichsmodul dann mit relevanten Informationen aus dem Maschinendatenmodell verglichen werden, wobei die relevanten Maschineninformationen insbesondere folgende Informationen umfassen können: Maschinenhubhöhe, maximale Maschinentraglast und/oder Maschinenreichweite. Soll beispielsweise ein für das Bauwerk geeigneter Kran ausgewählt werden, kann ein Kran gewählt werden, dessen Hubhöhe für die Bauwerkshöhe ausreicht, dessen Traglast für das Gewicht des schwersten zu versetzenden Bauteils ausreicht und dessen Reichweite für die Querschnittserstreckung des Bauwerks im Aufriss und/oder die maximale Entfernung zwischen der Bauteilanlieferungsstation und dem Bauteilbestimmungsort ausreicht. Sind im Maschinendatenmodell mehrere Krane enthalten, die die genannten Kriterien erfüllen, kann der kleinste Kran ausgewählt werden, der die genannten Anforderungen erfüllt und sozusagen den kleinsten Überschuß hinsichtlich der Kranleistungen besitzt.

Optional kann die Anbindung des Maschinendatenmodells an das Bauwerkdatenmodell auch dazu genutzt werden, um den Aufstellort der Baumaschine, insbesondere die Position des Krans, relativ zu dem zu errichtenden bzw. zu bearbeitenden Bauwerk automatisch zu bestimmen und/oder automatisch zu überprüfen. Ist eine Baumaschine ausgewählt, was in der vorgenannten Weise automatisiert durch das beschriebene Auswahlmodul oder alternativ auch händisch vom Planer selbst erfolgen kann, kann ein Positionsbestimmungsmodul anhand relevanter Maschinendaten, die aus dem Baumaschinenmodell ausgelesen werden und beispielsweise die Reichweite und/oder die Hubhöhe und/oder den Kollisions- und/oder Arbeitsbereich der Baumaschine umfassen können, sowie anhand relevanter Bauwerksdaten, die aus dem Bauwerksdatenmodell ausgelesen werden und beispielsweise Bauwerksbemaßungen und/oder -konturen und/oder Baustellen-Topographiedaten und/oder Zufahrtswege und/oder Material-Anlieferungsstationen umfassen können, automatisch einen geeigneten Aufstellort für die Baumaschine bestimmen. Alternativ oder zusätzlich kann das genannte Positions- oder Aufstellort-Bestimmungsmodul eine eventuell händisch vom Planer festgelegten Position der Baumaschinen anhand der genannten Kriterien überprüfen, insbesondere dahingehend, ob bei dem bestimmten Aufstellort die Reichweite bzw. der Arbeitsort der Baumaschine für die von der Baumaschine auszuführenden Arbeiten ausreichend ist und/oder ob Kollisionen des Arbeitsbereichs der Baumaschine mit Bauwerkskonturen und/oder anderen topografischen Gegebenheiten der Baustelle wie beispielsweise Bäumen oder Nachbargebäuden auftreten können, um dann ggfs. den Aufstellort der Baumaschine freigeben oder einen alternativen Aufstellort vorschlagen zu können.

Nach erfolgreicher Bestimmung und/oder Überprüfung des Maschinenaufstellorts kann das BIM- bzw. Bauwerkdatenmodell von dem genannten Aufstellort-Bestimmungsmodul bezüglich des Aufstellort entsprechend aktualisiert werden.

Ferner kann das Aufstellort-Bestimmungsmodul anhand der vorgenannten Kollisionsprüfung auch automatisch den Arbeitsbereich der jeweils ausgewählten Baumaschine automatisch begrenzen und das Bauwerkdatenmodell durch die festgelegten Arbeitsbereichsbeschränkungen aktualisieren. Wie noch erläutert wird, kann die Baumaschinen-Steuervorrichtung hinsichtlich einer Arbeitsbereichsbegrenzungs-Funktion entsprechend angepaßt bzw. parametrisiert werden.

Alternativ oder zusätzlich zu einer solchen automatischen Auswahl und/oder Überprüfung der Arbeitsposition der Baumaschine kann ein Logistik-Modul anhand digitaler Informationen aus dem Bauwerkdatenmodell die Reihenfolge und/oder die Zeitpunkte der Anlieferung von Teilen der ausgewählten Baumaschine und/oder die für die Anlieferung benötigten Transporteinheiten automatisch festlegen. Das genannte Logistik-Modul kann hierbei ebenfalls in Form eines Software-Tools und/oder eines Funktionsbausteins in das Baumaschinenmodell integriert sein, ggfs. aber als separater Baustein auch an das Bauwerkdatenmodell angebunden werden. Insbesondere können durch das Logistik-Modul unter Zuhilfenahme der Daten aus dem Bauwerkdatenmodell sog. Kolli-Listen oder Transportlisten automatisiert erstellt werden.

Die Reihenfolge und/oder die Zeitpunkte der Anlieferung von Teilen kann hierbei unter Berücksichtigung der für das Bauwerk auszuführenden Arbeiten und/oder des Fortgangs und/oder Status des Bauwerks festgelegt werden, die als digitale Informationen im Bauwerkdatenmodell abgelegt sein können. Zusätzlich zu den genannten Informationen aus dem Bauwerkdatenmodell kann das Logistik-Modul auch relevante Informationen aus dem Maschinendatenmodell berücksichtigen, insbesondere relevante Informationen zu der ausgewählten Baumaschine wie beispielsweise deren Zerlegbarkeit und/oder des Gewichts der Maschinenbauteile und/oder der Größe der Maschinenbauteile und/oder der Aufstellreihenfolge der Maschinenbauteile. Wird beispielsweise ein Kran angeliefert, können Tieflader- und/oder Containereinheiten in passender Größe und/oder passender Traglast in der Reihenfolge ausgewählt bzw. bestellt werden, mit Hilfe derer die Kranteile in der passenden Reihenfolge zum passenden Zeitpunkt an der Baustelle angeliefert werden können, ggfs. unter Berücksichtigung der dort vorhandenen Zufahrtswege.

Darüber hinaus kann auch ein Simulator zum Simulieren des Betriebs einer für die Errichtung und/oder Bearbeitung des Bauwerks ausgewählten Baumaschine an das Bauwerkdatenmodell angebunden werden, wobei bestimmte digitale Informationen aus dem Bauwerkdatenmodell für die Generierung der virtuellen Realität des Simulators genutzt werden können. Der Simulator kann hierbei eine Schnittstelle zur Anbindung des Bauwerkdatenmodells besitzen, wobei ein Identifikations- und/oder Auslesebaustein vorgesehen sein kann, um relevante Bauwerkscharakteristika wie Bauwerkkonturen, Umgebungskonturen oder andere verwendete Baumaschinen aus dem Bauwerkdatenmodell auslesen und dem Generator zum Generieren der virtuellen Realität bereitstellen können, anhand derer dann die Animation der Baumaschine und/oder der Baumaschinenumgebung generiert werden kann, in der ein Maschinenführer dann bestimmte Maschinenaufgaben trainieren kann.

In einer weiteren, nicht erfindungsgemäßen Weiterbildung kann die Anbindung des BIM- bzw. Bauwerkdatenmodells an den Simulator dazu genutzt werden, um verschiedene Zustände und Bauphasen des zu errichtenden bzw. zu bearbeitenden Bauwerks anhand der digitalen Informationen aus dem Bauwerkdatenmodell auf der Anzeigeeinrichtung des Simulators darstellen bzw. als Animation anzeigen zu können, anhand derer dann ein Baumaschinenführer am Simulator bestimmte Sonderaufgaben wie beispielsweise Sonderhübe eines Krans trainieren kann. Für die Steuerung des Simulators und/oder die Generierung der virtuellen Realität am Simulator können auch Maschinendaten bereitgestellt und/oder eingespielt werden, die von dem vorgenannten Maschinendatenmodell bereitgestellt werden können und die jeweils ausgewählte Baumaschine charakterisieren können, um die virtuelle Realität am Simulator der für das Bauwerk ausgewählten Baumaschine anpassen zu können.

Optional können auch mehrere Simulatoren an das Bauwerksdatenmodell angebunden werden, um das Zusammenspiel mehrerer Baumaschinen, die für die Errichtung bzw. Bearbeitung des Bauwerks ausgewählt sein können, zu simulieren und zu trainieren. Solche mehreren Simulatoren können einerseits in der vorgenannten Weise digitale Informationen betreffend das Bauwerk beziehen, um die virtuelle Realität anhand der Bauwerksdaten aus dem Bauwerkdatenmodell generieren zu können, beispielsweise verschiedene Bauphasen und Zustände des zu errichtenden Bauwerks. Andererseits können jeweils digitale Informationen aus dem Maschinendatenmodell eingespielt bzw. eingelesen werden, um die virtuellen Darstellungen an den Simulatoren an die jeweils verwendeten Baumaschinen anpassen zu können.

Vorzugsweise kann dabei das Zusammenspiel der beiden Simulatoren durch einen übergeordneten Simulator-Steuerungsbaustein miteinander koordiniert werden, insbesondere derart, dass an dem einen Simulator veranlasste bzw. vorgenommene Maschinenaktionen wie beispielsweise Kranhübe an dem jeweils anderen Simulator angezeigt und/oder berücksichtigt werden können. Soll beispielsweise mittels zwei Kranen gemeinsam ein Bauteil angehoben und an einem bestimmten Ort abgesetzt werden, können an dem einen Simulator vorgenommene Kranbewegungen und sich daraus ergebende Bauteilbewegungen an dem anderen Simulator angezeigt und ggfs. auch in Form von dynamischen Reaktionen angezeigt werden. Lässt beispielsweise der Kranführer an dem einen Simulator das gemeinsam angehobene Bauteil ruckartig ein Stück weit absenken, kann dies zu dynamischen Reaktionen auch an dem anderen simulierten Kran führen, die dann in Form von dynamischen Reaktionen am Führerstand des anderen Simulators wiedergegeben werden können.

Insbesondere können virtuelle Darstellungen der einen Baumaschine, die die am zugehörigen Simulator eingegebenen Steuerbefehle und sich daraus ergebende Bewegungen berücksichtigen können, an der Anzeigeeinheit des jeweils anderen Simulators eingeblendet und animiert werden. Hierdurch können das Zusammenspiel und ggfs. auch sich ergebende Kollisionen gemeinsam an mehreren Simulatoren trainiert werden.

Um eine realitätsnahe Simulation des Baumaschinenbetriebs zu erreichen, kann beispielsweise vorgesehen werden, dass Maschinenreaktionen auf am Steuerstand eingegebene Steuerbefehle beispielsweise in Form von Maschinenbewegungen und/oder -verformungen nicht nur in Form einer virtuellen Darstellung auf der Anzeigevorrichtung des Simulators dargestellt werden, sondern in eine mit der Kran- bzw. Maschinenreaktion einhergehende, tatsächliche Bewegung des Steuerstands des Simulators umgesetzt werden, um dem Nutzer die dynamischen Maschinenreaktionen realitätsnäher vermitteln zu können und erfahren lassen zu können. Der Steuerstand, der beispielsweise einen Bedienersessel umfassen kann, kann hierzu nicht mehr statisch starr im Raum, bzw. am Boden montiert sein, sondern von einer Antriebsvorrichtung im Raum bewegbar, insbesondere in Abhängigkeit der von dem Bewegungsbestimmungsmodul bestimmten Bewegungen und/oder Verformung der Maschinenkomponenten bewegbar sein. Bestimmt das Bewegungsbestimmungsmodul Auslenkungen von Maschinenkomponenten wie beispielsweise des Kranturms durch Stellbewegungen oder Verformungen, die auf die Position der echten Kranführerkabine Einfluss hätten, kann die Antriebsvorrichtung von einer Antriebssteuervorrichtung entsprechend angesteuert werden, um die Bewegung der Kranführerkabine nachbilden und den Steuerstand entsprechend bewegen zu können. Wird beispielsweise am Steuerstand ein Befehl zum Verdrehen des Krans um eine aufrechte Achse eingegeben, kann der Steuerstand von der Antriebsvorrichtung entsprechend um die aufrechte Achse verdreht werden. Wird beispielsweise der Steuerbefehl zum Anheben einer schweren Last eingegeben, was in der Realität zu einem leichten Nicken der Kranstruktur unter leichter Verwindung des Turms führen kann, kann der Steuerstand von der Antriebsvorrichtung leicht nach vorne verfahren und/oder leicht nach vorne verkippt werden.

Um eine besonders realitätsnahe Nachbildung der im echten Betrieb auftretenden Steuerstandbewegungen ermöglichen zu können, kann die Antriebsvorrichtung mehrachsig bewegbar ausgebildet sein und/oder sowohl rotatorische als auch translatorische Bewegungen ausführen. Insbesondere kann der Steuerstand mehrachsig beweglich gelagert sein und die Antriebsvorrichtung zumindest eine aufrechte Drehachse und zumindest eine liegende Wippachse und/oder zwei liegend ausgerichtete Translationsachsen umfassen. Um auch komplexe Steuerstandsbewegungen nachbilden zu können, kann die Antriebsvorrichtung drei Rotations- bzw. Kippachsen aufweisen bzw. dreiachsig rotatorisch arbeitend ausgebildet sein und dreiachsig translatorisch arbeitend ausgebildet sein, so dass der Steuerstand um alle drei Raumachsen verdreht bzw. verkippt und in alle drei Raumrichtungen translatorisch verfahren werden kann. Je nach zu simulierendem Kran- bzw. Maschinentyp können auch einfachere Ausbildungen der Antriebsvorrichtung mit weniger Bewegungsachsen in Betracht kommen.

Optional kann das Bewegungsbestimmungsmodul derart ausgebildet sein, dass die Kran- bzw. Maschinenstruktur nicht als starre, sozusagen unendlich steife Struktur betrachtet wird, sondern als elastisch verformbare und/oder nachgiebige und/oder relativ weiche Struktur angenommen wird, die - zusätzlich zu den Stellbewegungsachsen der Maschine wie beispielsweise der Auslegerwippachse oder der Turmdrehachse - Bewegungen und/oder Positionsänderungen durch Verformungen der Strukturbauteile zulässt. Die Berücksichtigung der Beweglichkeit der Maschinenstruktur infolge von Strukturverformungen unter Last oder dynamischen Belastungen kann gerade bei langgestreckten, schlanken und von den statischen und dynamischen Randbedingungen her bewusst - unter Berücksichtigung der notwendigen Sicherheiten - ausgereizten Strukturen wie bei Kranen von Bedeutung sein, da hier spürbare Bewegungsanteile beispielsweise für die Kranführerkabine, aber auch die Lasthakenposition durch die Verformungen der Strukturbauteile hinzukommen können. Um hier eine tatsächlich realistische Schulung bzw. ein realitätsnahes Training ermöglichen zu können, kann das Bewegungsbestimmungsmodul solche Verformungen der Maschinenstruktur unter statischen oder dynamischen Belastungen berücksichtigen.

Insbesondere kann die Bestimmungseinrichtung zur Bestimmung solcher Strukturverformungen eine Berechnungseinheit aufweisen, die diese Strukturverformungen anhand eines gespeicherten Berechnungsmodells in Abhängigkeit der am Steuerstand eingegebenen Steuerbefehle berechnet. Ein solches Modell kann ähnlich einem Finite-Elemente-Modell aufgebaut sein oder ein Finite-Elemente-Modell sein, wobei vorteilhafterweise jedoch ein gegenüber einem Finite-Elemente-Modell deutlich vereinfachtes Modell verwendet wird.

Die vom Bewegungsbestimmungsmodul berücksichtigten Strukturteilverformungen können einerseits bei der Ansteuerung der Antriebsvorrichtung zum Bewegen des Steuerstands berücksichtigt werden, so dass der Steuerstand die durch die Strukturteilverformungen auftretenden Steuerstandbewegungen nachbildet. Alternativ oder zusätzlich können die bestimmten Strukturteilverformungen auch bei der Berechnung der virtuellen Darstellung der Maschinenumgebung und/oder der darin sichtbaren Maschinenkomponenten berücksichtigt werden, beispielsweise dahingehend, dass in der virtuellen Darstellung die Durchbiegung des Auslegers dargestellt wird oder der Horizont der Kranumgebung ein Stück nach oben gefahren wird, um ein leichtes Nach-vorne-Nicken der Kranführerkabine durch beispielsweise eine Turmverformung nachzubilden.

Um das Realitätsempfinden des Nutzers des Simulators weiter zu erhöhen können auf der Anzeigevorrichtung optional die von dem grafischen Simulationsmodul bereitgestellten virtuellen Darstellungen aus der Simulationswelt mit Livebildern aus dem Steuerstand, die beispielsweise Bewegungen des Fernsteuer-Einrichtung-Nutzers zeigen können, überlagert werden. Insbesondere können auf der Anzeigevorrichtung einerseits die vom grafischen Simulationsmodul generierten virtuellen Darstellungen der Maschinenumgebung und/oder der darin sichtbaren Maschinenkomponenten und andererseits am Steuerstand aufgenommene Livebilder einer Livekamera gleichzeitig und überlagert dargestellt werden. Eine solche Überlagerung von Bildern aus der Simulationswelt und Livebildern kann dem Fernsteuer-Einrichtungnutzer ein besonders starkes Gefühl der Realitätsnähe geben.

Vorteilhafterweise kann hierzu als Anzeigevorrichtung eine am Kopf tragbare, insbesondere brillenartig ausgebildete Anzeigevorrichtung beispielsweise in Form einer Virtual-Reality-Brille und eine vorteilhafterweise ebenfalls am Kopf tragbare, beispielsweise als Helmkamera ausgeführte oder in die genannte Virtual-Reality-Brille integrierte Kamera Verwendung finden, die die genannten Livebilder bereitstellt, die zusammen mit der künstlich generierten, virtuellen Darstellung auf der Anzeigevorrichtung, insbesondere der Virtual-Reality-Brille, dargestellt werden. Es können jedoch auch einfachere Anzeigeeinrichtungen bspw. in Form von Bildschirmen verwendet werden.

Des Weiteren kann der genannte Simulator auch als Fernsteuereinrichtung zum Fernsteuern eines "echten" Krans oder einer "echten" Baumaschine verwendet werden, wobei vorteilhafterweise zwischen der Baumaschine einerseits und dem dann eine Fernsteuer-Einrichtung bildenden Simulator andererseits eine Kommunikationsverbindung vorgesehen werden kann, über die am Steuerstand der Fernsteuer-Einrichtung eingegebene Steuerbefehle an die Steuereinrichtung des Krans, der Baumaschine und/oder des Flurförderzeugs übertragbar sein können. Der "echte" Kran bzw. das jeweils ferngesteuerte "echte" Gerät kann die am Steuerstand des Simulators bzw. der Fernsteuer-Einrichtung eingegebenen Steuerbefehle ausführen, gleichzeitig kann die am Steuerstand generierte virtuelle Darstellung der Maschinenumgebung und der darin sichtbaren Maschinenkomponenten anzeigen, wie die Maschine die Steuerbefehle umsetzt. Hierbei kann vorgesehen sein, die am echten Gerät erfassten Bewegungsparameter und Sensorsignale auf die Fernsteuer-Einrichtung rückzuspeisen und dort für die Generierung der virtuellen Darstellung der Maschinenumgebung zu verwenden, um sicherzustellen zu können, dass tatsächlich eine der tatsächlichen Maschinenumgebung und -stellung entsprechende Darstellung auf der Anzeigevorrichtung der Fernsteuer-Einrichtung angezeigt wird.

Alternativ oder zusätzlich zu einer eingangs beschriebenen automatischen Anpassung der Arbeitsbereichsbegrenzung kann in einer vorteilhaften Weiterbildung der Erfindung auch eine Baufortschritt-Überwachung vorgesehen sein, bei der mittels einer geeigneten Erfassungseinrichtung wie beispielsweise einer Kamera und/oder einem Scanner und/oder eines Flugobjektes der Ist-Zustand des Bauwerks und/oder dessen Umgebung erfasst und mit digitalen Informationen aus dem Bauwerkdatenmodell abgeglichen wird. Zur Erfassung des Ist-Zustands können mit einer Kamera Bauwerkskonturen erfasst und/oder vermessen, und/oder vorhandene Bauteile mittels eines Barcode-Scanners eingelesen und/oder mittels eines RFID-Lesers erfasst, und/oder Positionsdaten von Bauteilen und/oder Bauwerkskonturen mittels eines Ortsbestimmers bspw. in Form eines GPS- oder Radarmeßmoduls bestimmt werden.

Anhand des Vergleichs der erfassten Ist-Daten mit den zugehörigen relevanten BIM-Daten kann eine Bestimmung erfolgen, in welcher Bauphase sich das Bauwerk aktuell befindet. Anhand dieser Bestimmung der aktuellen Bauphase durch ein entsprechendes Bauphasen-Bestimmungsmodul können dann verschiedene unterstützende und/oder automatisierte Maßnahmen eingeleitet werden. Beispielsweise kann an einer Anzeigevorrichtung der Baumaschine angezeigt werden, welche Arbeitsschritte als nächstes auszuführen sind und/oder wohin ein an der Anlieferungsstation angeliefertes Bauteil bestimmungsgemäß zu verbringen ist. Beispielsweise kann anhand eingespielter Informationen aus dem Bauwerkdatenmodell auf einer Anzeigeeinheit im Führerstand der Baumaschine und/oder im Steuerstand der Fernsteuereinrichtung eine virtuelle Darstellung des Bauwerks in seinem jeweiligen Zustand generiert werden, in der das aktuell zu verfahrende bzw. zu verbringende Bauteil und dessen Position angezeigt wird, sodass beispielsweise ein Kranführer sehen kann, welcher Hub zu machen ist und wohin ein am Haken aufzunehmendes Bauteil verbracht werden soll.

In vorteilhafter Weiterbildung der Erfindung kann der Steuerung der Baumaschine auch ein Hubsteuerungsbaustein zur automatisierten Hubsteuerung anhand von relevanten Informationen aus dem Bauwerkdatenmodell bereitgestellt werden. Der genannte Hubsteuerungsbaustein kann dabei halbautomatisch oder vollautomatisch arbeitend ausgebildet sein, um im Zusammenspiel mit Eingabe oder Freigabe oder Bestätigungsbefehlen des Maschinenführers oder ggfs. auch ohne solche ergänzenden Steuerbefehle einen Hub automatisiert auszuführen. Hierzu kann bei halbautomatischer Ausbildung der Maschinenführer das von der Baumaschine zu verbringende Bauteil identifizieren. Alternativ kann auch eine automatisierte Bauteilerkennung erfolgen, beispielsweise mittels einer geeigneten Erfassungseinrichtung wie einem Strichcode-Leser und/oder einem RFID-Code-Erkenner und/oder einem Scanner und/oder einer Kamera, um beispielsweise eine am Kranhaken eines Krans aufgenommene Last zu identifizieren. Alternativ oder zusätzlich zu der genannten RFID-Erkennung kann auch mit einem LWID, d.h. im niederfrequenten bzw. Low Wave-Bereich arbeitenden Kennungssystem gearbeitet werden. Insbesondere kann auch mit einem sogenannten RuBee-Erkennungssystem gearbeitet werden, wobei ein solches RuBee-System bidirektional on demand kommuniziert, wobei beispielsweise in einem Frequenzbereich von größenordnungsmäßig 100-150 kHz, ggf. aber auch höher bis zu 450 kHz gearbeitet werden kann. Derartige RuBee-Tags können einen Mikroprozessor mit einem Speicherbaustein umfassen und eine IP-Adresse verwenden. Insbesondere kann die RuBee-Erkennung auch Magnetwellen verwenden und/oder induktiv kommunizieren, wobei sich die RuBee-Erkennung insbesondere durch ihre Robustheit gegenüber Störungen durch Metallteile und Feuchtigkeit auszeichnet und somit besonders für den Baumaschinen- oder Kraneinsatz geeignet ist.

Für ein erfasstes und identifiziertes Bauteil wird dann anhand des Bauwerkdatenmodells und relevanter digitaler Informationen hieraus bestimmt, zu welchem Ort des Bauwerks das Bauteil verbracht werden soll, wobei hierfür insbesondere Positionsdaten für das jeweilige Bauteil aus dem Bauwerkdatenmodell genutzt werden können.

Das Hubsteuerungsmodul kann aus den vom Bauwerkdatenmodell bereitgestellten Daten betreffend das identifizierte Bauteil und ggfs. weiterer Bauwerkscharakteristika wie Bauwerkskonturen den Verfahrweg für den automatisierten Hub berechnen, ggfs. unter Berücksichtigung von weiteren Topographiedaten der Baustelle wie Zufahrtswegen etcetera.

Alternativ oder zusätzlich zu einem solchermaßen automatisierten Verfahren der Baumaschine durch den genannten Hubsteuerungsbaustein kann auch ein Sperrbaustein vorgesehen sein, der im Zusammenspiel mit dem Bauwerkdatenmodell einen entsprechenden Hub bzw. einen entsprechenden Arbeitsschritt der Baumaschine sperren kann, insbesondere wenn beispielsweise ein entsprechendes Bauteil bereits verbaut wurde oder ein für das Verbauen des Bauteils benötigter Anschlussbaustein noch nicht verbaut wurde.

Der genannte Sperrbaustein kann insbesondere im Zusammenspiel mit der vorgenannten Baufortschrittsüberwachung arbeiten, insbesondere dergestalt, dass anhand des zuvor erläuterten Soll-/Ist-Abgleichs des Baufortschritts ermittelt wird, ob das Bauwerk bereit ist, das jeweilige Bauteil entsprechend zu verbringen. Hierdurch können unnütze Hübe mit Bauteilen vermieden werden, die noch nicht verbaut werden können bzw. deren Einbauposition noch nicht bereit ist.

Der Sperrbaustein und/oder der vorgenannte Hubsteuerungsbaustein können in die Maschinen-Steuerungsvorrichtung integriert und/oder als Software-Tool herunterladbar und/oder einspielbar sein, oder auch in Form eines gespeicherten, separaten Bausteins an die Maschinen-Steuerungsvorrichtung angebunden werden. Vorteilhafterweise können der Sperrbaustein und/oder der Hubsteuerungsbaustein mittels digitaler Informationen aus dem Bauwerkdatenmodell parametrisiert und/oder modifiziert werden.

Die Erfindung wird nachfolgend anhand eines bevorzugten Ausführungsbeispiels und zugehörigen Zeichnungen näher erläutert. In den Zeichnungen zeigen:
- Fig. 1:: Eine schematische Darstellung einer Baumaschine in Form eines Krans, dessen Steuerung an ein Bauwerkdatenmodell angebunden ist und eine Last in einem nicht einsehbaren Bereich hinter einem Gebäude manövriert,
- Fig. 2:: Eine schematische Diagramm-Darstellung der Anbindung eines Bauwerkdatenmodells an die Steuerung des Krans aus Fig. 1 sowie an ein Maschinendatenmodell zur Unterstützung der Bauplanung sowie an einen Simulator zum Simulieren des Betriebs des Krans mit Hilfe von Daten aus dem Bauwerkdatenmodell.

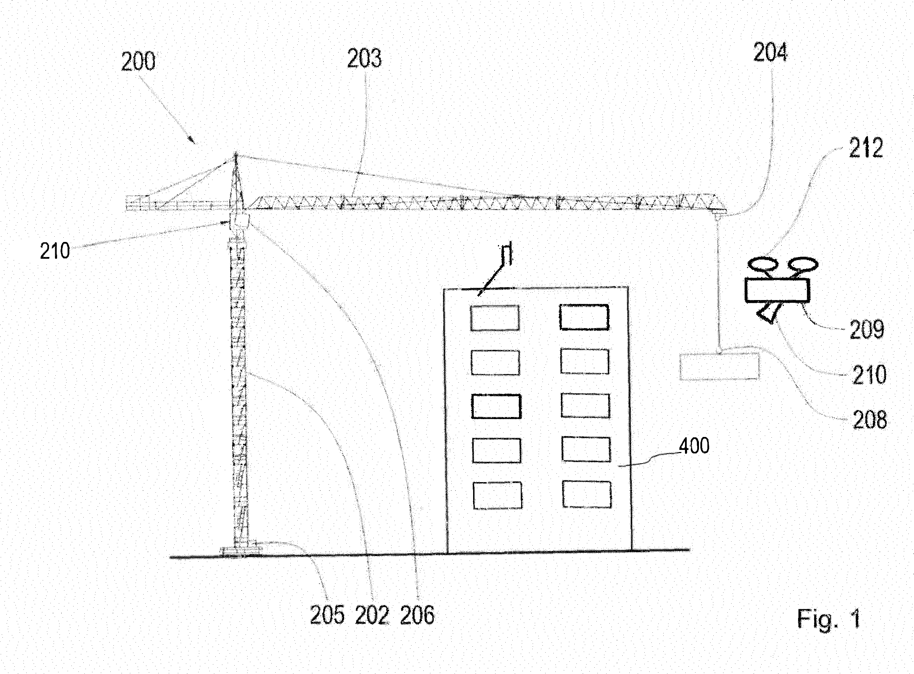

Wie Fig. 1 zeigt, kann ein Kran 200, der in noch zu erläuternder Weise an ein Bauwerkdatenmodell 300 angebunden ist, als Turmdrehkran ausgebildet sein, dessen Turm 202 einen Ausleger 203 trägt, an dem eine Laufkatze 204 verfahrbar gelagert ist. Der Ausleger 203 kann zusammen mit dem Turm 202 oder auch ohne den Turm 202 - je nach Ausbildung des Krans als Oben- oder Untendreher - um eine aufrechte Achse verdreht werden, wozu ein Drehwerksantrieb vorgesehen ist. Der Ausleger 203 könnte ggf. auch auf- und niederwippbar um eine liegende Querachse ausgebildet sein, wobei ein geeigneter Wippantrieb beispielsweise im Zusammenspiel mit der Auslegerabspannung vorgesehen sein könnte. Die genannte Laufkatze 204 kann mittels einer Katzfahrwinde oder eines anderen Katzfahrantriebs verfahren werden.

Anstelle des gezeigten Krans 200 könnte jedoch auch ein anderer Kran beispielsweise in Form eines Teleskopauslegerkrans oder auch eine Baumaschine eines anderen Typs wie beispielsweise ein Bagger Verwendung finden und an das BIM- bzw. Bauwerkdatenmodell 300 angebunden werden.

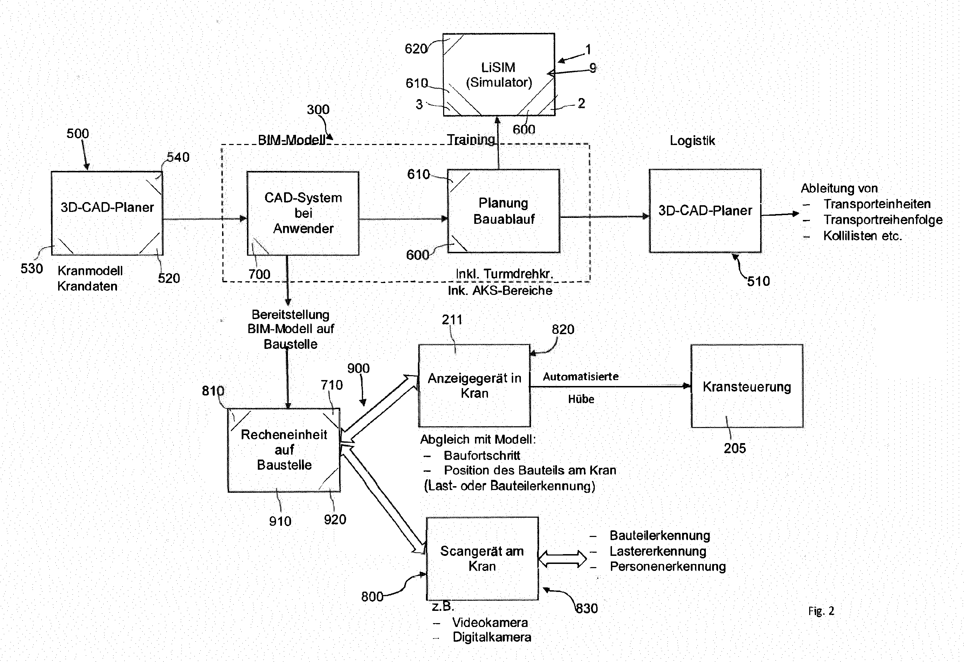

Wie Fig. 2 zeigt, kann der Kran 200 bereits in der Planungsphase berücksichtigt werden. Hierzu kann ein Baumaschinenmodell 500, das in der genannten Weise digitale Informationen über verschiedene Baumaschinen, insbesondere verschiedene Krane einschließlich des Krans 200 aus Fig. 1 enthalten kann, an ein Bauwerkdatenmodell 300 angebunden werden. Das genannte Baumaschinenmodell 500 kann in Form eines herunterladbaren Software- Tools bzw. -Bausteins bereitgestellt werden, der eine Schnittstelle aufweist, die es erlaubt, das Baumaschinenmodell 500 an das Bauwerkdatenmodell 300 anzubinden, sodass die beiden miteinander kommunizieren und Daten austauschen können.

Mit Hilfe der Anbindung des genannten Maschinendatenmodells 500 kann der Planungsprozess vereinfacht werden. Insbesondere können in der eingangs näher erläuterten Weise die Auswahl des Krans, die Positionierung des Krans relativ zu dem zu erstellenden Bauwerk und die Arbeitsbereiche des Krans 200 vorgenommen bzw. bestimmt werden. Hierzu können in das Baumaschinenmodell 500 und/oder in das Bauwerkdatenmodell 300 geeignete Software- und/oder Hardwarebausteine integriert sein, insbesondere ein Maschinen-Auswahlmodul 520, ein Aufstellort-Bestimmungsmodul 530, ein Kollisions-Bestimmungsmodul 700 und ein Arbeitsbereichs-Einstellmodul 710.

Wie Fig. 2 zeigt, kann auch ein Logistik-Modul 510 an das Bauwerkdatenmodell 300 angebunden werden, wobei das genannte Logistik-Modul 510 in das Maschinendatenmodell 500 integriert sein und/oder in Form eines Software-Bausteins herunterladbar oder auch als separater Baustein ausgebildet sein kann und vorteilhafterweise eine an das Bauwerkdatenmodell 300 angepasste Schnittstelle umfasst, sodass das Logistik-Modul 510 und das Bauwerkdatenmodell 300 miteinander kommunizieren und Daten austauschen können.

Mit Hilfe des genannten Logistik-Moduls 510 können insbesondere logistische Funktionen betreffend die ausgewählte Baumaschine automatisiert ausgeführt werden. Insbesondere können für den Transport der Baumaschine, beispielsweise des Krans 200 aus Fig. 1, benötigte Transporteinheiten festgelegt und/oder die Reihenfolge und Zeitpunkte der Transportjobs der Transporteinheiten festgelegt und/oder sog. Kolli-Listen oder Transportlisten erstellt werden.

Ferner kann ein Simulator 1 an das Bauwerkdatenmodell 300 angebunden sein, um anhand von digitalen Informationen betreffend das zu erstellende bzw. zu bearbeitende Bauwerk die von dem Simulator 1 bereitgestellte virtuelle Realität zu generieren.

Ein Steuerstand 2 des Simulators 1 kann hierbei in an sich bekannter Weise einen Bedienersitzplatz beispielsweise in Form eines Bedienersessels umfassen, um den herum diverse Eingabemittel zum Eingeben von Steuerbefehlen angeordnet sein können. Die genannten Eingabemittel können beispielsweise einen Joystick, ein Touchscreen, Steuerhebel, Eingabetasten und -schalter, Drehregler, Schieberegler und Ähnliches aufweisen.

Der Bedienerplatz kann hierbei von einer Führerstandwandung umgeben sein, die einer Kabineneinhausung entsprechen kann und Fensterbereiche aufweisen kann, die bei echten Kranführerkabinen verglast sind, im Steuerstand 2 des Simulators 1 jedoch in einer bestimmten Farbe eingefärbt sein können, beispielsweise mit einer grünen Folie beschichtet sein können, um mittels Green-Screen-Technik eine virtuelle Maschinenumgebung einblenden zu können.

Der Steuerstand 2 kann vorteilhafterweise auf einer Bewegungsplattform montiert sein, mittels derer der Steuerstand mehrachsig beweglich ist. Die Bewegungsplattform kann dabei vorteilhafterweise mehrachsig beweglich ausgebildet sein, insbesondere um alle drei Raumachsen x, y und z verkipp- bzw. verdrehbar und entlang dieser Achsen translatorisch verschieblich.

Den Bewegungsachsen der Bewegungsplattform können dabei Aktoren einer Antriebsvorrichtung zugeordnet sein, beispielsweise in Form von Elektromotoren und/oder Hydraulikzylindern und/oder Hydraulikmotoren, um den Steuerstand 2 um die bzw. entlang der genannten Achsen bewegen zu können.

Die Antriebsvorrichtung kann dabei von einer Bewegungssteuervorrichtung angesteuert werden, die beispielsweise durch einen Industrie-PC realisiert sein kann.

Die genannte Bewegungssteuervorrichtung kann dabei insbesondere Teil eines Bewegungsbestimmungsmoduls sein, mittels dessen Kranbewegungen und/oder Positionen und/oder Ausrichtungen von Krankomponenten wie beispielsweise des Auslegers oder des Turms und auch Verwindungen von Strukturbauteilen wie des Auslegers oder des Turms in Abhängigkeit der jeweils am Steuerstand eingegebenen Steuerbefehle bestimmt werden können. Das genannte Bewegungsbestimmungsmodul kann sozusagen die Auswirkungen der eingegebenen Steuerbefehle auf den zu simulierenden Kran bestimmen, d.h. welche Bewegungen, Positionen, Ausrichtungen und Verwindungen der Krankomponenten sich infolge eingegebener Steuerbefehle am zu simulierenden Kran ergeben würden und kann entsprechende, die genannten Größen charakterisierende Bewegungssignale ausgeben.

Das genannte Bewegungsbestimmungsmodul kann die genannten Bewegungsgrößen hierbei nicht bzw. nicht vollständig durch Berechnung anhand eines Rechenmodells bestimmen, sondern kann auf tatsächliche Hardwarekomponenten in Form von Antriebs- und Steuerungskomponenten zurückgreifen, die tatsächliche Bewegungen ausführen können und den entsprechenden Hardwarekomponenten an einem echten Kran nachgebildet sein können.

Der genannte Simulator 1 kann beispielsweise dazu ausgebildet sein, den Betrieb der jeweils ausgewählten Baumaschine auf Basis von bereitgestellten Informationen aus dem Bauwerkdatenmodell 300 zu simulieren, wobei ein grafisches Simulationsmodul 9 zum Generieren einer virtuellen Darstellung des zu errichtenden und/oder zu bearbeitenden Bauwerks auf einer Anzeigevorrichtung 3 des Steuerstands 2 des Simulators 1 unter Zuhilfenahme der digitalen Informationen aus dem Bauwerkdatenmodell vorgesehen sein kann.

Vorteilhafterweise kann die Steuerung des Simulators 1 ein Bauphasenauswahlmodul 600 umfassen, mittels dessen aus dem Bauwerkdatenmodell 300 verschiedene digitale Informationen zu verschiedenen Bauphasen des Bauwerks ausgelesen bzw. identifiziert werden können, auf Basis derer die Anzeigevorrichtung 3 des Simulators 1 dann das Bauwerk in verschiedenen Bauphasen anzeigen kann, sodass ein Maschinenführer verschiedene Spezialaufgaben wie beispielsweise Sonderhübe in den verschiedenen Bauphasen trainieren kann.

Hierzu kann ein Aufgabensimulationsmodul 610 vorgesehen sein, dass mit dem grafischen Simulationsmodul 9 verbunden ist, derart dass auf der Anzeigevorrichtung 3 des Simulators zusätzlich zu dem Bauwerk auch eine virtuelle Darstellung des zu bearbeitenden Bauteils und dessen Versetzwegs eingeblendet werden kann, so wie das Bauteil zu versetzen ist.

Ohne in der Zeichnung eigens dargestellt zu sein, können auch zwei oder mehrere Simulatoren 1 an das Bauwerkdatenmodell angebunden sein, die grundsätzlich jeweils in der vorgenannten Weise ausgebildet sein können. Vorteilhafterweise kann hierbei eine übergeordnete Simulatoren-Steuervorrichtung 620 vorgesehen sein, die die grafischen Simulationsmodule 9 der mehreren Simulatoren 1 miteinander koordinieren kann, insbesondere dergestalt, dass Steuerbefehle und entsprechende Maschinenaktionen, die an dem einen Simulator erzeugt werden können, auch in dem anderen Simulator berücksichtigt werden können, insbesondere in der dort angezeigten virtuellen Darstellung und ggfs. auch in den erzeugten dynamischen Reaktionen des Bedienersessels, wie dies zuvor erläutert wurde.

Der genannte Simulator 1 kann vorteilhafterweise auch als Fernsteuereinrichtung genutzt werden, mittels derer der in Fig. 1 gezeigte Kran 200 ferngesteuert werden kann. Vorteilhafterweise kann die Fernsteuereinrichtung dabei auch für die Fernsteuerung mehrerer Baumaschinen, die auf derselben oder verschiedenen Baustellen aufgestellt sein können, genutzt werden, sodass die Fernsteuereinrichtung sozusagen ein Kontrollzentrum bildet.

Alternativ oder zusätzlich zu einer solchen virtuellen Darstellung kann jedoch am Steuerstand 2 auch eine echte, kameragenerierte Darstellung der Kranumgebung und/oder des Lasthakens verwendet werden. Hierzu kann am Kran 200 zumindest eine Kamera montiert sein, deren Livebilder an den Steuerstand 2 übertragen werden. Eine solche Kamera 220 kann beispielsweise an der Kranführerkabine 210 des ferngesteuerten Krans 200 montiert sein und vorteilhafterweise zumindest näherungsweise eine Blickachse haben, die der Blickachse eines Kranführers in der Kranführerkabine 210 entspricht und/oder von der Kranführerkabine 210 zum Lasthaken hin geht.

Alternativ oder zusätzlich können aber auch andere Kameras und/oder Darstellungen aus anderen Perspektiven aufgenommen und an den Steuerstand übertragen werden, um dort angezeigt zu werden. Insbesondere kann eine Flugdrohne verwendet werden, die mit zumindest einer Kamera ausgerüstet ist und ferngesteuert relativ zum Kran 200 bewegt werden kann.

Um den Lasthaken 208, der mit einem von der Laufkatze 204 ablaufenden Hubseil 207 verbunden sein kann, oder eine daran aufgenommene Last bzw. die Umgebung des Lasthakens 208 auch dann sehen zu können, wenn sich der Lasthaken 208 außerhalb des Sichtbereichs der Kranführerkabine 206 bzw. des Kranführers befindet, beispielsweise wenn - wie Fig. 1 zeigt - die Last hinter einem Gebäude abzusetzen ist, kann eine Flugdrohne 209 vorgesehen sein, an der zumindest eine Kamera 210 montiert ist, mittels derer ein Kamerabild vom Lasthaken 208 und/oder der Lasthakenumgebung bereitgestellt werden kann. Das genannte Kamerabild ist vorteilhafterweise ein Live- oder Echtzeitbild im Sinne eines Fernseh- oder Videobilds und kann von der Kamera 210 der Flugdrohne 209 drahtlos zu einer Anzeigeeinheit 211 und/oder der Steuervorrichtung 205 des Krans 201 übertragen werden, wobei die genannte Anzeigeeinheit 211 beispielsweise ein Maschinenführerdisplay nach Art eines Tablets oder eines Bildschirms oder eines Monitors sein kann, der in der Kranführerkabine 206 montiert sein kann. Wird in der zuvor genannten Weise ein Fernsteuerstand oder eine mobile Bedieneinheit zum Steuern des Krans 200 verwendet, kann die genannte Anzeigeeinheit 211 in dem Fernsteuerstand oder an der mobilen Bedieneinheit vorgesehen sein.

Die Flugdrohne 209 kann mit einer Fernsteuereinrichtung 212 versehen sein, die es erlaubt, die Flugdrohne 209 fernzusteuern, insbesondere die Flugsteueraggregate wie beispielsweise Rotorblätter anzusteuern, um die Flugposition der Flugdrohne 209 fernsteuern und/oder die Kamera 210 fernsteuern zu können, insbesondere hinsichtlich des Schwenkwinkels bzw. der Blickachse der Kamera 210 relativ zu dem Korpus der Flugdrohne 209 und/oder der Brennweite der Kamera 210.

Ein entsprechendes Fernsteuermodul kann in der Kranführerkabine 206 und/oder dem Fernsteuerstand oder der mobilen Bedieneinheit vorgesehen sein, beispielsweise mit entsprechenden Joysticks ausgestattet sein. Um eine einfache Bedienung zu ermöglichen, kann jedoch auch eine Sprachsteuerung und/oder eine Menüsteuerung für die Flugdrohne 209 vorgesehen sein, beispielsweise um aus mehreren vorbestimmten Relativpositionen der Flugdrohne 209 relativ zum Kran eine gewünschte Relativposition auszuwählen. Dies kann beispielsweise dadurch erfolgen, dass per Sprachsteuerung und/oder Menüsteuerung "Drohnenposition 1" eingegeben wird, die vorprogrammiert bzw. vorbestimmt in der Positionssteuervorrichtung 213 abgelegt sein kann.

Wie Fig. 2 zeigt, ist der Kran 200 an das Bauwerkdatenmodell 300 angebunden. Um das BIM- bzw. das Bauwerkdatenmodell 300 auf der Baustelle bereitzustellen, kann ein Baustellenrechner 910 vorgesehen sein, der im Bereich des zu errichtenden Bauwerks positioniert werden kann. Hierdurch können lange Datenwege und Zeitversatz reduziert werden und eine zeitversatzfreie bzw. -arme Interaktion zwischen dem Bauwerkdatenmodell 300 und dem Kran 200 realisiert werden.

Durch die Anbindung des Krans 200 an das Bauwerkdatenmodell 300 werden verschiedene Kranfunktionen bzw. allgemein Steuerungsfunktionen der entsprechenden Baumaschine in Abhängigkeit digitaler Daten aus dem Bauwerkdatenmodell 300 angepasst bzw. parametrisiert. Hierzu können mittels der in Fig. 2 gezeigten Datenkommunikationseinrichtung 900 entsprechende digitale Informationen aus dem Bauwerkdatenmodell 300 an den Kran 200 gegeben werden. Die genannte Datenkommunikationseinrichtung 900 kann insbesondere den Baustellenrechner 910 mit der Steuerungsvorrichtung 205 des Krans 200 verbinden.

Ein Steuerungs-Konfigurationsmodul 920, das in der Steuervorrichtung 205 des Krans 200 implementiert sein kann, aber auch in dem Baustellenrechner 910 vorgesehen sein kann, ist dazu vorgesehen, die genannten Steuerungsfunktionen der Steuervorrichtung 205 des Krans 200 entsprechend anzupassen. Insbesondere kann dieses Steuerungs-Konfigurationsmodul 920 die Arbeitsbereichsbegrenzungs-Funktion des Krans 200, die in dessen Steuervorrichtung 205 implementiert sein kann, mittels digitaler Daten aus dem Bauwerkdatenmodell 300 an verschiedene Bauphasen und dementsprechend wachsende Bauwerkswände und Hindernisse anpassen.

Unabhängig von einer solchen Anpassung der Arbeitsbereichsbegrenzung kann die Anbindung an das Bauwerkdatenmodell 300 auch dazu genutzt werden, eine automatisierte Bauphasenüberwachung zu realisieren. Hierzu kann einerseits mittels einer geeigneten Erfassungseinrichtung 800 der Ist-Zustand des Bauwerks bestimmt werden, wobei die genannte Erfassungseinrichtung 800 grundsätzlich verschieden ausgebildet sein kann. Beispielsweise kann die Erfassungseinrichtung 800 zumindest eine Kamera und/oder einen geeigneten bildgebenden Sensor umfassen, beispielsweise in Form der an der Flugdrohne 209 montierten Kamera 210 oder einer am Kran 200 montierten Kamera 220. Eine den erzeugten Bildern nachgeordnete Bildverarbeitungseinrichtung kann spezifische Charakteristika erfassen, beispielsweise Bauwerkshöhe, bebaute Grundrissfläche, Umrisskonturen oder ähnliches, welche den Baufortschritt charakterisieren. Alternativ oder zusätzlich zu solchen Kameras oder bildgebenden Sensoren können auch andere Erfassungsmittel wie beispielsweise ein Scanner oder ein RFID-Leser vorgesehen sein, um zu erfassen, ob bestimmte Bauteile bereits am Bauwerk verbaut sind oder nicht. Ein solcher Scanner oder RFID-Leser kann beispielsweise am Kranhaken 208 angebracht sein, oder auch in Form eines mobilen Geräts verwendet werden, mittels dessen verbaute Bauteile händisch gescannt werden können.

Der durch die Erfassungseinrichtung 800 erfasste Ist-Zustand des Bauwerks kann dann durch ein Bauphasen-Bestimmungsmodul 810, das beispielsweise in dem Baustellenrechner 910 implementiert sein kann, mit digitalen Informationen aus dem Bauwerkdatenmodell 300 verglichen werden, um aus dem Vergleich die jeweilige Bauphase bestimmen zu können.

Auf Basis der bestimmten Bauphase kann der Kran 200 verschiedene Funktionen ausführen. Beispielsweise ist es bereits hilfreich, wenn die jeweils erreichte Bauphase auf einer Anzeigevorrichtung am Kran 200 angezeigt wird, sei es in dessen Kranführerkabine 206 oder am Steuerstand 2 der Fernsteuereinrichtung.

Mit Hilfe eines Steuerungs-Konfigurationsmoduls 920, das in dem Baustellenrechner 910, insbesondere aber auch in der Steuervorrichtung 205 des Krans 200 implementiert sein kann, können jedoch auch weitergehende Steuerungsfunktionen am Kran 200 adaptiert werden. Beispielsweise kann am genannten Anzeigegerät am Kran oder dessen Fernsteuervorrichtung eine virtuelle Darstellung der jeweils nächsten von der Baumaschine auszuführenden Arbeitsaufgabe angezeigt werden, beispielsweise dergestalt, dass in die virtuelle Darstellung des Bauwerks in dessen jeweiliger Bauphase das jeweils nächste zu verbauende Bauteil angezeigt und dessen Einbauposition am Bauwerk eingeblendet wird. Alternativ oder zusätzlich kann auch ein Verfahrweg in die Darstellung eingeblendet werden.

In noch vorteilhafterer Weise können auch automatisierte Hübe durch den Kran 200 ausgeführt werden, insbesondere auf Basis der vorgenannten Bauphasenüberwachung und der damit einhergehenden Bestimmung des nächsten Arbeitsschrittes. Hierzu ist eine Erfassungseinrichtung 830 vorgesehen, mittels derer ein im Aufnahme- bzw. Arbeitsbereich des Krans 200 befindliches Bauteil erfasst wird, insbesondere dahingehend, ob es das Bauteil ist, das im nächsten Arbeitsschritt verbaut werden soll. Die genannte Erfassungsvorrichtung 830 kann beispielsweise einen Barcode-Scanner oder einen RFID-Leser umfassen, der am Kranhaken angebracht sein kann. Es versteht sich jedoch, dass auch andere Erfassungsmittel verwendet werden können, um das aufzunehmende Bauteil zu identifizieren.

Wird auf diese Weise beispielsweise festgestellt, dass das im nächsten Arbeitsschritt zu verbauende Bauteil am Kranhaken 208 aufgenommen ist, veranlasst das genannte Steuerung-Konfigurationsmodul 920 die Kransteuervorrichtung 205 auf Basis der digitalen Informationen aus dem Bauwerkdatenmodell 300 dazu, einen automatisierten Hub auszuführen, um das Bauteil an den bestimmungsgemäßen Verbauort zu verbringen.

Wie Fig. 2 andeutet, können mittels geeigneter Scangeräte bzw. Erfassungsvorrichtungen auch andere Erkennungsfunktionen realisiert werden, beispielsweise einer Personenerkennung, insbesondere dahingehend, ob Personen im dem Last-Verfahrweg des automatisierten Hubs sind oder sich Personen unautorisiert am Kran befinden etcetera.

## Patentansprüche

1. Verfahren zum Steuern des Betriebs einer Baumaschine, insbesondere eines Krans (200), unter Verwendung eines Bauwerkdatenmodells (300), das digitale Informationen über ein zu errichtendes und/oder zu bearbeitendes Bauwerk enthält, wobei folgende Schritte ausgeführt werden:
- Bereitstellen von digitalen Informationen aus dem Bauwerkdatenmodell (300) an eine Baumaschine, insbesondere einen Kran (200),
- Beeinflussung zumindest einer Steuerungsfunktion einer Baumaschinen-Steuereinrichtung (205) in Abhängigkeit der bereitgestellten digitalen Informationen aus dem Bauwerkdatenmodell (300),
wobei mittels einer Erfassungsvorrichtung (830) ein im Aufnahme- und/oder Arbeitsbereich der Baumaschine befindliches Bauteil automatisch erfasst wird, **dadurch gekennzeichnet, dass** in Abhängigkeit des erfassten Bauteils aus dem Bauwerkdatenmodell (300) digitale Informationen betreffend die Bearbeitung des erfassten Bauteils einschließlich Positionsdaten, die den Bestimmungsort des Bauteils angeben, und Verfahrwegsdaten, die den Verfahrweg des Bauteils angeben, bereitgestellt werden und von der Baumaschinen-Steuervorrichtung (205) das Bauteil in Abhängigkeit der genannten Positionsdaten und Verfahrwegsdaten automatisch gehoben und/oder verfahren, sowie an den Bestimmungsort verbracht wird.

2. Verfahren nach dem vorhergehenden Anspruch, wobei das im Aufnahme- und/oder Arbeitsbereich der Baumaschine befindliche Bauteil von der Erfassungseinrichtung (30) mittels eines im niederfrequenten Bereich von 100-450 kHz, insbesondere 100-150 kHz, arbeitenden LWID-Kennungssystem erfasst und identifiziert wird.

3. Verfahren nach dem vorhergehenden Anspruch, wobei das im Aufnahme- und/oder Arbeitsbereich der Baumaschine befindliches Bauteil mit einem bidirektional on demand kommunizierenden Kennungselement, das einen Mikroprozessor und einen Speicherbaustein umfaßt, gekennzeichnet wird und für die Erfassung des Bauteils mit dem genannten Kennungselement mittel Magnetwellen und/oder induktiv kommuniziert wird.

4. Verfahren nach einem der vorhergehenden Ansprüche, wobei das im Aufnahme- und/oder Arbeitsbereich der Baumaschine befindliches Bauteil von der Erfassungseinrichtung (30) mittels eines Strichcode-Lesers und/oder eines RFID-Code-Erkenners und/oder eines Scanners und/oder einer Kamera automatisch erfasst und identifiziert wird.

5. Verfahren nach dem vorhergehenden Anspruch, wobei das im Aufnahme- und/oder Arbeitsbereich der Baumaschine befindliches Bauteil von der Erfassungseinrichtung (30) mittels eines an einem Kranhaken der Baumaschine angebrachten Strichcode-Lesers und/oder eines an einem Kranhaken der Baumaschine angebrachten RFID-Code-Erkenners automatisch erfasst und identifiziert wird.

6. Verfahren nach einem der vorhergehenden Ansprüche, wobei der Verfahrweg für das automatische Heben und/oder Verfahren, der anhand der aus dem Bauwerkdatenmodell (300) erhaltenen digitale Informationen betreffend das erfasste Bauteils bestimmt wurde, anhand zusätzlicher Bauwerkscharakteristika wie Bauwerkskonturen und weiteren Topographiedaten der Baustelle wie Zufahrtswegen automatisch angepaßt wird, wobei insbesondere
- eine von der Baumaschinensteuervorrichtung (205) berücksichtigte Arbeitsbereichsbegrenzungs-Funktion durch ein Arbeitsbereichsbegrenzungs-Einstellmodul (710) in Abhängigkeit von digitalen Informationen aus dem Bauwerkdatenmodell (300) verändert und die Arbeitsbereichsbegrenzungs-Funktion in Abhängigkeit von Baufortschritten am zu errichtenden und/oder zu bearbeitenden Bauwerk unter Berücksichtigung von digitalen Informationen aus dem Bauwerkdatenmodell automatisch aktualisiert angepasst wird, und/oder
- mittels zumindest einer Erfassungseinrichtung (800), die zumindest eine Kamera (210, 220), einen Scanner und/oder ein Flugobjekt umfasst, ein Ist-Zustand des Bauwerks, insbesondere das Vorhandensein bestimmter Bauwerksteile, erfasst wird, wobei von einem Baufortschritt-Bestimmungsmodul (810) der erfasste Ist-Zustand des Bauwerks mit digitalen Informationen aus dem Bauwerkdatenmodell (300) verglichen wird und in Abhängigkeit des Vergleichs bestimmte digitale Informationen aus dem Bauwerkdatenmodell (300) an die Baumaschinen-Steuervorrichtung (205) bereitgestellt werden.

7. Baumaschine, insbesondere Kran (200) oder Bagger, mit einer Baumaschinen-Steuervorrichtung (205) zum Steuern von Arbeitsaggregaten der Baumaschine, einer Datenkommunikations-Einrichtung (900) zum Empfangen und Verarbeiten von digitalen Informationen aus einem Bauwerkdatenmodell (300), einem Steuerungs-Konfigurationsmodul (920) zur Beeinflussung zumindest einer Steuerungsfunktion der Baumaschinen-Steuereinrichtung (205) in Abhängigkeit der empfangen digitalen Informationen aus dem Bauwerkdatenmodell (300), und einer Erfassungsvorrichtung (830) zum Erfassen eines im Aufnahme- und/oder Arbeitsbereich der Baumaschine befindlichen Bauteils, **dadurch gekennzeichnet, dass** die Datenkommunikations-Einrichtung (900) dazu ausgebildet ist, in Abhängigkeit des erfassten Bauteils aus dem Bauwerkdatenmodell (300) digitale Informationen betreffend die Bearbeitung des erfassten Bauteils einschließlich Positionsdaten, die den Bestimmungsort des Bauteils angeben, und Verfahrwegsdaten, die den Verfahrweg des Bauteils angeben, der Baumaschinen-Steuervorrichtung (205) bereitzustellen, wobei das Steuerungs-Konfigurationsmodul (920) dazu ausgebildet ist, die Baumaschinensteuervorrichtung (205) zu veranlassen, die Arbeitsaggregate der Baumaschine in Abhängigkeit der genannten Positionsdaten und Verfahrwegsdaten automatisch anzuheben und/oder zu verfahren, um das erfasste Bauteil an den genannten Bestimmungsort zu verbringen.

8. Baumaschine nach dem vorhergehenden Anspruch, wobei die Erfassungsvorrichtung (830) ein im niederfrequenten Bereich von 100-450 kHz, insbesondere 100-150 kHz, arbeitendes LWID-Kennungssystem zum Erfassen eines an dem Bauteil angebrachten, bidirektional on demand kommunizierenden Kennungselements, das einen Mikroprozessor und einen Speicherbaustein umfaßt, mittels Magnetwellen und/oder induktiver Kommunikation aufweist.

9. Baumaschine nach einem der beiden vorhergehenden Ansprüche, wobei die Erfassungsvorrichtung (830) eine Kamera (210) und/oder einen bildgebenden Sensor und/oder einen Barcodescanner und/oder einen RFID-Leser aufweist.

10. Baumaschine nach einem der vorhergehenden Ansprüche, wobei die Baumaschinen-Steuervorrichtung (205) einen Hubsteuerungsbaustein zur automatisierten Hubsteuerung anhand erhaltener Informationen aus dem Bauwerkdatenmodell aufweist, wobei der genannte Hubsteuerungsbaustein dazu ausgebildet ist, aus den vom Bauwerkdatenmodell bereitgestellten Daten betreffend das identifizierte Bauteil und weiteren Bauwerkscharakteristika wie Bauwerkskonturen den Verfahrweg für den automatisierten Hub unter Berücksichtigung von weiteren Topographiedaten der Baustelle wie Zufahrtswegen zu berechnen.

11. Baumaschine nach einem der vorhergehenden Ansprüche, wobei ein Sperrbaustein zum Sperren eines Hubs oder eines Verfahrens der Baumaschine anhand von Daten aus dem Bauwerkdatenmodell, wenn das automatisch erfaßte und identifizierte Bauteil bereits verbaut wurde oder ein für das Verbauen des Bauteils benötigter Anschlussbaustein noch nicht verbaut wurde.

12. Baumaschine nach einem der vorhergehenden Ansprüche, wobei der genannte Sperrbaustein dazu ausgebildet ist, anhand eines Soll-/Ist-Abgleichs des Baufortschritts zu ermitteln, ob das Bauwerk bereit ist, das jeweilige Bauteil entsprechend zu verbringen.

13. Baumaschine nach einem der vorhergehenden Ansprüche, wobei das Steuerungs-Konfigurationsmodul (910) dazu ausgebildet ist,
- eine von der Baumaschinen-Steuervorrichtung (205) berücksichtigte Arbeitsbereichsbegrenzungs-Funktion in Abhängigkeit von digitalen Informationen aus dem Bauwerkdatenmodell (300) zu verändern, und/oder
- in Abhängigkeit von digitalen Informationen aus dem Bauwerkdatenmodell (300) in Abhängigkeit einer bestimmten Bauphase auf einer Anzeigevorrichtung (820; 211), die an der Baumaschine oder einem Steuerstand (2) zum Fernsteuern der Baumaschine angeordnet ist, eine virtuelle Darstellung des Bauwerks gemäß dem bestimmten Ist-Zustand und/oder eine virtuelle Darstellung der nächsten von der Baumaschine auszuführenden Arbeitsaufgabe anzuzeigen, und/oder
- in Abhängigkeit von digitalen Daten aus dem Bauwerkdatenmodell (300) eine virtuelle Darstellung des nächsten zu bearbeitenden Bauteils und der Einbauposition des genannten Bauteils am Bauwerk anzuzeigen.

## Claims

1. Method for controlling the operation of a construction machine, in particular a crane (200), using a structure data model (300) that includes digital information on a structure to be erected and/or to be worked, wherein the following steps are carried out:
- providing digital information from the structure data model (300) to a construction machine, in particular to a crane (200); and
- influencing at least one control function of a construction machine control device (205) depending on the provided digital information from the structure data model (300),
wherein a construction element located in the pick-up region and/or working range of the construction machine is automatically detected by means of a detection apparatus (830), **characterized in that** digital information relating to the processing of the detected construction element, including position data indicating the target position of the construction element and travel path data that indicate the travel path of the construction element, is provided from the structure data model (300) depending on the detected construction element and the construction element is automatically lifted and/or displaced by the construction machine control device (205) depending on said position data and travel path data, and transferred to the target position.

2. Method according to the preceding claim, wherein the construction element located in the pick-up region and/or working range of the construction machine is detected and identified by the detection device (30) by means of an LWID detection system operating in the low-frequency range of 100-450 kHz, in particular 100-150 kHz.

3. Method according to the preceding claim, wherein the construction element located in the pick-up region and/or working range of the construction machine is marked with an identification element which communicates bidirectionally on demand and which comprises a microprocessor and a memory module, and, for the detection of the construction element, communication is effected with said identification element by means of magnetic waves and/or inductively.

4. Method according to any one of the preceding claims, wherein the construction element located in the pick-up region and/or working range of the construction machine is automatically detected and identified by means of a barcode reader and/or an RFID code detector and/or a scanner and/or a camera.

5. Method according to the preceding claim, wherein the construction element located in the pick-up region and/or working range of the construction machine is automatically detected and identified by the detection device (30) by means of a barcode reader attached to a crane hook of the construction machine and/or an RFID code detector attached to a crane hook of the construction machine.

6. Method according to any one of the preceding claims, wherein the travel path for the automatic lifting and/or travelling, which was determined on the basis of the digital information obtained from the structure data model (300) relating to the detected building construction element, is automatically adapted on the basis of additional structure characteristics such as structure contours and further topography data of the construction site such as access routes, wherein in particular
- a working region limitation function taken into account by the construction machine control device (205) is changed by a working range limitation setting module (710) depending on digital information from the structure data model (300) and the working region limitation function is automatically updated and adapted depending on construction progresses at the structure to be erected and/or to be worked while taking account of digital information from the structure data model, and/or
- an actual state of the structure, in particular the presence of determined structure parts, is detected by means of at least one detection device (800), which comprises at least one camera (210, 220), a scanner and/or a flying object, wherein the detected actual state of the structure is compared with digital information from the structure data model (300) by a construction progress determination module (810), and wherein certain digital information from the structure data model (300) determined depending on the comparison is provided to the construction machine control device (205).

7. Construction machine, in particular crane (200) or excavator, comprising a construction machine control device (205) for controlling working units of the construction machine, a data communication device (900) for receiving and processing digital information from a construction data model (300), a control configuration module (920) for influencing at least one control function of the construction machine control device (205) depending on the digital information received from the construction data model (300), and a detection device (830) for detecting a construction element located in the pick-up and/or working area of the construction machine, **characterized in that** the data communication device (900) is configured to provide the construction machine control device (205) with digital information relating to the processing of the detected construction element, including position data indicating the target position of the construction element and travel path data indicating the travel path of the construction element, depending on the detected construction element from the construction data model (300), wherein the control configuration module (920) is adapted to cause the construction machine control device (205) to automatically raise and/or move the working units of the construction machine depending on said position data and travel path data in order to transfer the detected construction element to said target position.

8. Construction machine according to the preceding claim, wherein the detection device (830) comprises an LWIO identification system operating in the low-frequency range of 100-450 kHz, in particular 100-150 kHz, for detecting an identification element, which is attached to the construction element and communicates bidirectionally on demand and which comprises a microprocessor and a memory module, by means of magnetic waves and/or inductive communication.

9. Construction machine according to any one of the two preceding claims, wherein the detection device (830) comprises a camera (210) and/or an imaging sensor and/or a barcode scanner and/or an RFID reader.

10. Construction machine according to any one of the preceding claims, wherein the construction machine control device (205) comprises a lift control module for automated lift control on the basis of information obtained from the construction data model, wherein said lift control module is configured to calculate the travel path for the automated lift from the data provided by the construction data model relating to the identified construction component and further construction characteristics such as construction contours, taking into account further topography data of the construction site such as access routes.

11. Construction machine according to any one of the preceding claims, wherein a blocking module for blocking a stroke or a displacement of the construction machine on the basis of data from the construction data model, if the automatically detected and identified component has already been installed or a connecting module required for installing the component has not yet been installed.

12. Construction machine according to any one of the preceding claims, wherein the blocking module is configured to determine, on the basis of a target/actual comparison of the construction progress, whether the structure is ready to move the respective component accordingly.

13. Construction machine in accordance with the preceding claim, wherein the control configuration module (910) is configured
- to change a working range limitation function taken into account by the construction machine control device (205) depending on digital information from the structure data model (300); and/or
- to display a virtual representation of the structure in accordance with the determined actual state and/or a virtual representation of the next work job to be carried out by the construction machine on a display apparatus (820; 211) that is arranged at the construction machine or at a control station (2) for the remote control of the construction machine depending on digital information from the structure data model (300) depending on a determined construction phase; and/or
- to display a virtual representation of the next construction element to be worked and the installed position of said construction element at the structure depending on digital data from the structure data model (300).

## Revendications

1. Procédé pour planifier et commander le fonctionnement d'un engin de chantier, en particulier d'une grue (200), au moyen d'un modèle de données de bâtiment (300), qui contient des informations numériques sur un bâtiment à édifier et/ou à traiter, en exécutant les étapes suivants :
- fourniture d'informations numériques provenant du modèle de données de bâtiment (300) à un engin de chantier, notamment une grue (200),
- influencer au moins une fonction de commande du moyen de commande de l'engin de chantier (205) en fonction des informations numériques reçues provenant du modèle de donnés de bâtiment (300),
un élément de construction se trouvant dans la zone de réception et/ou de travail de l'engin de chantier étant détecté automatiquement au moyen d'un dispositif de détection (830), **caractérisé en ce que**, en fonction de l'élément de construction détecté, des informations numériques concernant le traitement de l'élément de construction détecté, y compris des données de position, des données de déplacement et des données d'emplacement, sont fournies par le modèle de données de bâtiment (300), qui indiquent le type de destination de l'élément de construction, et des données de déplacement qui indiquent le trajet de déplacement de l'élément de construction, sont fournies et le élément de construction est automatiquement saisi et/ou déplacé par le dispositif de commande de machine de chantier (205) en fonction des données de position et des données de trajet de déplacement mentionnées, et est amené au lieu de destination.

2. Procédé selon la revendication précédente, dans lequel l'élément de construction se trouvant dans la zone de réception et/ou de travail de l'engin de chantier est détecté et identifié par le dispositif de détection (30) au moyen d'un système d'identification LWID fonctionnant dans la plage basse fréquence de 100-450 kHz, en particulier de 100-150 kHz.

3. Procédé selon la revendication précédente, dans lequel l'élément de construction se trouvant dans la zone de prise et/ou de travail de l'engin de chantier est **caractérisé par** un élément d'identification communiquant à la demande de manière bidirectionnelle, qui comprend un microprocesseur et un module de mémoire, et dans lequel, pour la détection de l'élément de construction, on communique avec ledit élément d'identification au moyen d'ondes magnétiques et/ou par induction.

4. Procédé selon l'une des revendications précédentes, dans lequel l'élément de construction situé dans la zone de prise et/ou la zone de travail de l'engin de chantier est automatiquement détecté et identifié au moyen d'un lecteur de code-barres et/ou d'un détecteur de code RFID et/ou d'un scanner et/ou d'une caméra.

5. Procédé selon la revendication précédente, dans lequel l'élément de construction se trouvant dans la zone de réception et/ou de travail de l'engin de chantier est détecté et identifié automatiquement par le dispositif de détection (30) au moyen d'un lecteur de code à barres monté sur un crochet de grue de l'engin de chantier et/ou d'un identificateur de code RFID monté sur un crochet de grue de l'engin de chantier.

6. Procédé selon l'une des revendications précédentes, dans lequel la trajet de déplacement pour le levage et/ou le déplacement automatique, qui a été déterminé à l'aide des informations numériques obtenues à partir du modèle de données de bâtiment (300) concernant le élément de construction saisi, est adapté automatiquement à l'aide de caractéristiques de bâtiment supplémentaires telles que des contours de bâtiment et d'autres données topographiques du chantier telles que des voies d'accès, dans lequel en particulier
- une fonction de limitation de la zone de travail prise en compte par le dispositif de commande de l'engin de chantier (205) est modifiée par un module de réglage de limitation de zone de travail (710) en fonction d'informations numériques provenant du modèle de données de bâtiment (300) et la fonction de limitation de la zone de travail est adaptée de manière automatiquement actualisée en fonction des étapes de construction sur l'ouvrage à édifier et/ou à traiter en tenant compte des informations numériques provenant du modèle de données de bâtiment, et/ou
- un état actuel du bâtiment, en particulier la présence de certaines parties du bâtiment est détecté au moyen d'au moins un dispositif de détection (800), qui comprend au moins une caméra (210, 220), un scanner et/ou un objet volant, l'état réel détecté du bâtiment étant comparé, par un module de détermination d'avancement des travaux (810), à des informations numériques provenant du modèle de données de bâtiment (300) et, en fonction de la comparaison, certaines informations numériques provenant du modèle de données de bâtiment (300) étant fournies au dispositif de commande de l'engin de chantier (205).

7. Engin de chantier, en particulier grue (200) ou excavatrice, avec un dispositif de commande de l'engin de chantier (205) pour commander des unités de travail de l'engin de chantier, un dispositif de communication de données (900) pour recevoir et traiter des informations numériques provenant d'un modèle de données de bâtiment (300), un module de configuration de commande (920) pour influencer au moins une fonction de commande du dispositif de commande de l'engin de chantier (205) en fonction des informations numériques reçues provenant du modèle de données de bâtiment (300), et un dispositif de détection (830) pour détecter un élément de construction se trouvant dans la zone de réception et/ou de travail de l'engin de chantier, **caractérisé en ce que** le dispositif de communication de données (900) est conçu pour fournier au dispositif de commande de l'engin de chantier (205), en fonction de l'élément de construction saisi, des informations numériques concernant le traitement de l'élément de construction saisi, y compris des données de position qui indiquent le lieu de destination de l'élément de construction, et des données de trajet qui indiquent le trajet de déplacement de l'élément de construction, à partir du modèle de données de bâtiment (300),
le module de configuration de commande (920) étant conçu pour faire en sorte que le dispositif de commande de l'engin de chantier (205) soulève et/ou déplace automatiquement les unités de travail de l'engin de chantier en fonction desdites données de position et desdites données de trajet de déplacement, afin d'amener l'élément de construction détecté au ledit lieu de destination.

8. Engin de chantier selon la revendication précédente, dans laquelle le dispositif de détection (830) comprend un système d'identification LWIO fonctionnant dans la gamme des basses fréquences de 100-450 kHz, en particulier 100-150 kHz, pour détecter un élément d'identification attaché à l'élément de construction et communiquant de manière bidirectionnelle sur demande, qui comprend un microprocesseur et un module de mémoire, au moyen d'ondes magnétiques et/ou d'une communication inductive.

9. Engin de chantier selon l'une des deux revendications précédentes, dans lequel le dispositif de détection (830) comprend une caméra (210) et/ou un capteur d'imagerie et/ou un lecteur de code-barres et/ou un lecteur RFID.

10. Engin de chantier selon l'une des revendications précédentes, dans lequel le dispositif de commande de l'engin de chantier (205) présente un module de commande de levage pour la commande de levage automatisée à l'aide d'informations obtenues à partir du modèle de données de bâtiment, ledit module de commande de levage étant conçu pour calculer, à partir des données fournies par le modèle de données de bâtiment concernant l'élément de construction identifié et d'autres caractéristiques du bâtiment telles que les contours de du bâtiment, le trajet de déplacement pour le levage automatisé en tenant compte d'autres données topographiques du site de construction telles que les voies d'accès.

11. Engin de chantier selon l'une des revendications précédentes, dans lequel un module de blocage pour bloquer une course ou un déplacement de l'engin de chantier à l'aide de données provenant du modèle de données de bâtiment, lorsque l'élément de construction détecté et identifié automatiquement a déjà été installé ou qu'un module de raccordement nécessaire pour le montage de l'élément de construction n'a pas encore été installé.

12. Engin de chantier selon l'une des revendications précédentes, dans laquelle ledit module de blocage est configuré pour déterminer, à l'aide d'une comparaison théorique/réelle de l'avancement de la construction, si le bâtiment est prêt pour le déplacement de manière appropriée de l'élément de construction respectif.

13. Engin de chantier selon l'une des revendications précédentes, le module de configuration de commande (910) est conçu pour
- modifier une fonction de limitation de la zone de travail prise en compte par le dispositif de commande de l'engin de chantier (205) en fonction d'informations numériques provenant du modèle de données de bâtiment (300), et/ou
- afficher, en fonction d'informations numériques provenant du modèle de données de bâtiment (300) et en fonction d'une phase de construction déterminée, sur un dispositif d'affichage (820 ; 211) qui est disposé sur l'engin de chantier ou sur un poste de commande (2) pour la commande à distance de l'engin de chantier, une représentation virtuelle du bâtiment selon l'état réel déterminé et/ou une représentation virtuelle de la prochaine tâche de travail à exécuter par l'engin de chantier, et/ou
- afficher, en fonction de données numériques provenant du modèle de données de bâtiment (300), une représentation virtuelle du prochain élément de construction à traiter et de la position de montage dudit élément de construction sur le bâtiment.
